# EUROPEAN PATENT SPECIFICATION

(11) **EP 1 905 865 B1**
(45) Date of publication and mention of the grant of the patent: **09.04.2014**
(21) Application number: 06768138.7
(22) Date of filing: 12.07.2006
(51) Int. Cl.: C23C 14/34, C23C 14/08, H01B 13/00

(54) **SPUTTERING APPARATUS AND METHOD FOR MANUFACTURING TRANSPARENT CONDUCTING FILM**
SPUTTERVORRICHTUNG UND -VERFAHREN ZUR HERSTELLUNG EINES TRANSPARENTEN LEITFÄHIGEN FILMS
APPAREIL DE PULVÉRISATION ET PROCÉDÉ DE FABRICATION DE FILM CONDUCTEUR TRANSPARENT

(30) Priority: 19.07.2005 JP 2005208242
(43) Date of publication of application: 02.04.2008
(73) Proprietor: ULVAC, INC., Chigasaki-shi, Kanagawa 253-8543 (JP)
(72) Inventor: UKISHIMA, Sadayuki, ULVAC, Inc., Sammu-shi, Chiba 289-1226 (JP); TAKASAWA, Satoru, ULVAC, Inc., Sammu-shi, Chiba 289-1226 (JP); TAKEI, Hideo, ULVAC, Inc., Sammu-shi, Chiba 289-1226 (JP); ISHIBASHI, Satoru, ULVAC, Inc., Sammu-shi, Chiba 289-1226 (JP)
(74) Representative: Körber, Martin Hans
(86) International application number: PCT/JP2006/313874
(87) International publication number: WO 2007/010798

(56) References cited:
- JP-A- 63 007 360
- JP-A- 2005 171 328

## Description

### Technical Field

The present invention generally relates to a sputtering technique. Particularly, the invention relates to a sputtering apparatus causing fewer damages on a film-formed surface and a method for producing a transparent electroconductive film.

### Background Art

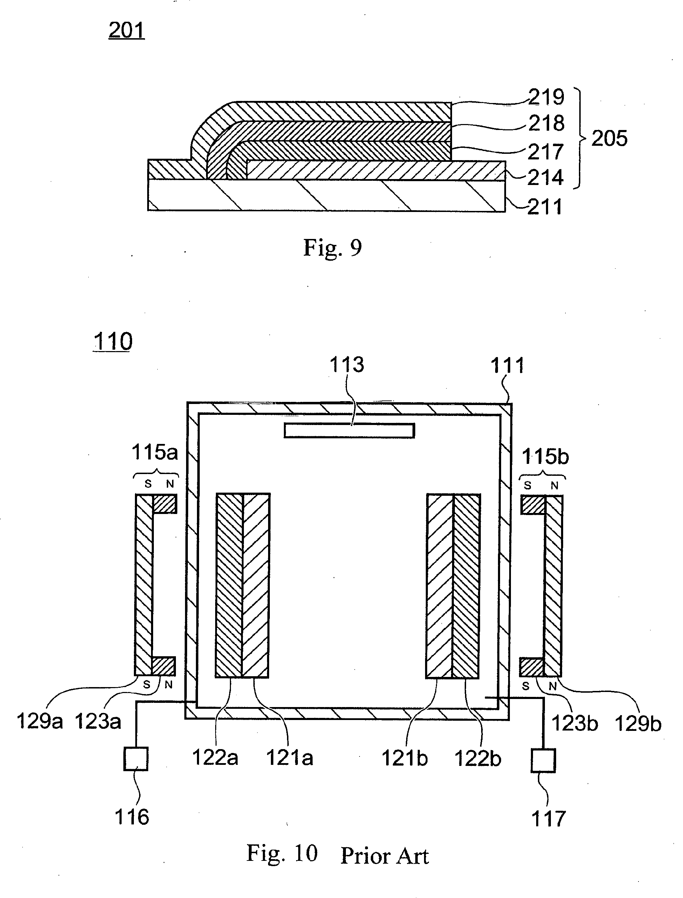

Recently, the organic EL devices have attracted public attention as display devices. Fig. 9 shows a schematically sectional view for illustrating the structure of an organic EL device 201.

In this organic EL device 201, a lower electrode 214, organic layers 217 and 218 and an upper electrode 219 are formed on a substrate 211 in this order. Applying voltage between the lower electrode 214 and the upper electrode 219 makes the organic EL device emit light inside the organic layer 217 and 218 or at an interface between them. When the upper electrode 219 is composed of a transparent electroconductive film such as an ITO film (a film of indium tin oxide), the emitted light is discharged outside through the upper electrode 219.

The vapor deposition method is mainly used for the formation of the upper electrode 219, as mentioned above.

The vapor deposition method has merit in that a good interface can be formed without any damage on the organic film when a cathode or a protective film of the organic EL device is formed because particles released from a vapor depositing source by sublimation or evaporation are neutral and have low energies (about a few eV).

However, since the vapor deposition technique gives poor adhesion to the organic film, there occurs an inconvenience that dark spots are formed or that the electrode peels off in a long-term driving.

Further, from the standpoint of productivity, there are problems in that, due to a point evaporating source, it is difficult to ensure a film thickness distribution in a large area, and that the maintenance cycle is short because of deterioration of an evaporating boat or difficulty in continuously supplying an evaporating material.

The sputtering method has been proposed as a technique to solve the above-mentioned problems. However, in a parallel flat plate type sputtering method in which an object to be film-formed is just faced to a target, there are disadvantages in that when an upper electrode of aluminum is formed on an organic layer, a light emission-starting voltage conspicuously rises or no light is emitted in a driving test for the organic EL device. The reason for this is that charged particles (Ar ions, secondary electrons, recoil Ar) or sputtered particles having high kinetic energies in the plasma are irradiated upon the organic film according to the sputtering method so that the interface of the organic film is broken to prevent smooth injection of electrons.

Under the above circumstances, countermeasures have been sought in the conventional art, and a sputtering apparatus 110 as shown in Fig. 10 is proposed.

The sputtering apparatus 110 includes a vacuum chamber 111. Inside the vacuum chamber 111, two targets 121a and 121b are fitted at each back face to backing plates 122a and 122b, and arranged such that a constant distance is interposed between the surfaces of the targets 121a and 121b and their surfaces are confronted, in parallel, to each other.

Magnet members 115a and 115b are arranged at the back sides of the backing plates 122a and 122b, respectively, and outside side walls of the vacuum chamber 111.

In the magnet members 115a and 115b, ring-shaped magnets 123a and 123b are attached to yokes 129a and 129b, respectively.

Each of the magnets 123a and 123b is arranged such that one magnetic pole 123a and 123b is faced to the target 121a or 121b, respectively, and the other magnetic pole is faced to a direction opposite to the target. In addition, different magnetic poles are faced to the targets 121a and 121b, respectively. In sum, when the north pole of one of the magnets, 123a, is faced to the target 121a, the south pole of the other magnet 123b is faced to the target 121b.

When the interior of the vacuum chamber 111 is evacuated by a vacuum evacuating system 116, and a sputtering gas is introduced through a gas introducing system 117 and voltage is applied to the targets 121a and 121b, a plasma of the sputtering gas is generated in a space sandwiched between the targets 121a and 121b, and the surfaces of the targets 121a and 121b are sputtered.

An object 113 to be film-formed is arranged on a side of the space sandwiched between the targets 121a and 121b, and a thin film is formed on a surface of the object 113 with sputtered particles which pop out obliquely from the targets 121a and 121b and which are released in the vacuum chamber 111.

In this sputtering apparatus 110, the object 113 to be film-formed is not exposed to the plasma, and the organic thin film exposed at the surface of the object 113 is not damaged because the space in which the targets 121a and 121b confront each other is surrounded by lines of magnetic force formed by the two magnets 123a and 123b, and the plasma is confined by the lines of magnetic force.

Further, there is merit in knowing that since the film is formed with the low-energy sputtered particles which pop out obliquely from the targets, damage on the thin film exposed at the surface of the object to be film-formed is small.

Patent Document 1: JP10-255987A

JP 63-007 360 A and JP 2005-171 328 A disclose related sputtering techniques.

### Disclosure of the Invention

### Problems to be solved by the Invention

When a thin film is to be formed on the surface of the objects to be film-formed one after another by using the above-mentioned sputtering apparatus 110, a passing/film-forming method may be applied, in which the surfaces of the objects to be film-formed are faced to the targets 121a and 121b and the objects are made to pass slowly through individual sides of the targets 121a and 121b.

However, a problem was found in that a film formed at a position distant from the targets 121a and 121b (that is, a film formed with particles which are irradiated obliquely onto the object) has a large resistance and a low transmittance.

### Measures to solve the Problems

The inventors in the present invention discovered that when a transparent electroconductive film is formed by the method that the targets are confronted to each other and an object to be film-formed is passed through sides of the targets to form a film, the object including elements of a film which is formed at a remote position from the targets causes increase in the resistivity and decrease in the transmittance.

This is the reason that the thin film formed outside of the region between the targets, which confront each other, includes very obliquely incident elements, and is a porous film.

The present invention, which has been made based on the above-mentioned knowledge, is directed to a sputtering apparatus according to claim 1 and a method for producing a transparent electroconductive film according to claim 7. Advantageous features are defined in the dependent claims.

### Effects of the Invention

The transparent electroconductive film having a uniform film thickness distribution, a small resistivity and a large transmittance can be obtained by the present invention.

Further, the transparent electroconductive film formed at a high film-forming rate can be formed on the less damaged transparent electroconductive film formed as an underlying layer. In particular, when an ITO thin film is formed on the organic thin film, the long-life organic EL device having less damage upon the organic thin film and a large amount of light emission can be obtained.

### Brief Description of the Drawings

Fig. 1 is a figure (1) for illustrating the sputtering apparatus according to the present invention and a film-forming step.
Fig. 2 is a figure (2) for illustrating the sputtering apparatus according to the present invention and the film-forming step.
Fig. 3 is a figure (3) for illustrating the sputtering apparatus according to the present invention and the film-forming step.
Figs. 4(a) and 4(b) are figures for illustrating lines of magnetic force of first and second magnet members.
Fig. 5 is a figure for illustrating another embodiment of the sputtering apparatus according to the present invention.
Figs. 6(a) to 6(d) show examples of magnet arrangements of the first and second magnet members.
Figs. 7(a) to 7(c) are figures for illustrating relative positional relationships between the first and second magnet members when moving along a straight line, and for showing the motion of one cycle.
Figs. 8(a) to 8(h) are figures for illustrating relative positional relationships between the first and second magnet members when moving along an ellipse, and for showing the motion of one cycle.
Fig. 9 is a schematic cross-sectional view for illustrating the structure of the organic EL device.
Fig. 10 is a figure for illustrating the conventional sputtering apparatus.
Fig. 11 shows a film thickness distribution, in a direction vertical to targets, of an ITO thin film formed by using the sputtering apparatus according to the present invention.
Fig. 12 shows a film thickness distribution, in a direction parallel to the targets, of the ITO thin film formed by using the sputtering apparatus according to the present invention.
Fig. 13 shows a resistivity distribution, in the direction vertical to the targets, of the ITO thin film formed by using the sputtering apparatus according to the present invention.
Fig. 14 shows the resistivity distribution, in the direction parallel to the targets, of the ITO thin film formed by using the sputtering apparatus according to the present invention.
Fig. 15 shows a transmittance distribution, in the direction vertical to the targets, of the ITO thin film formed by using the sputtering apparatus according to the present invention.

### Description of Reference Numeral

5 --- object to be film-formed, 10 --- sputtering apparatus, 11 --- vacuum chamber, 14 --- transporting path, 15a, 15d --- first magnet member, 15b, 15e --- second magnet member, 18 --- reaction gas-introducing system, 21a --- first target, 21b --- second target, 21c --- third target, 31, 33 --- shielding body (31 --- shielding plate, 33 --- tube)

### Best Mode for Carrying Out the Invention

### <Embodiments>

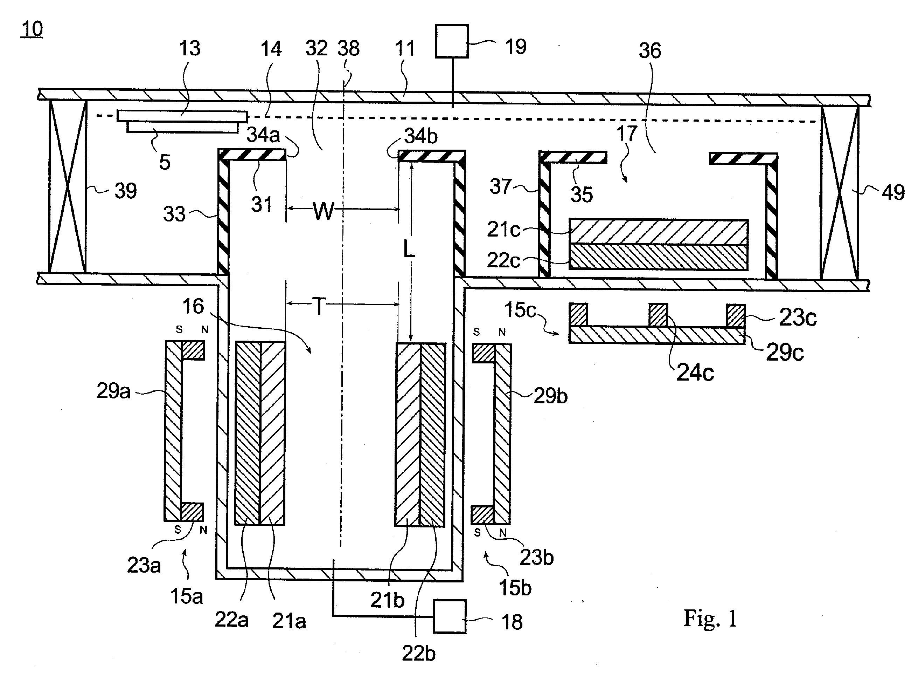

A reference number 10 of Fig. 1 denotes a sputtering apparatus as one embodiment according to the present invention.

This sputtering apparatus 10 comprises a vacuum chamber 11. The vacuum chamber 11 is connected to a L/UL chamber not shown through a gate valve 39. A reference number 49 denotes a gate valve for carrying-out.

The L/UL chamber is designed to allow loading and unloading of a carrier for holding an object to be film-formed. After the object to be film-formed is held on the carrier placed in the L/UL chamber and the L/UL chamber is shut out from the atmosphere, the gate valve 39 is opened, and the object is carried into the vacuum chamber 11 together with the carrier.

A transporting mechanism for transporting the carrier is fitted with the inside of the vacuum chamber 11. A reference number 14 of Fig. 1 denotes a transporting path along which the carrier is moved by the transporting mechanism. In this embodiment, the transporting path 14 is linear, and a reference number 13 denotes the carrier located on the transporting path 14. The object 5 to be film-formed is held by the carrier 13, and is to be transported straight along the transporting path 14 inside the vacuum chamber 11.

A first sputtering chamber 16 is provided in the vacuum chamber 11.

First and second targets 21a and 21b are arranged in the first sputtering chamber 16.

The first and second targets 21a and 21b are plate-like shapes, and their back faces are attached to backing plates 22a and 22b, respectively. The first and second targets 21a and 21b are arranged in parallel with their surfaces confronted and spaced from each other at a constant distance.

First and second magnet members 15a and 15b are arranged at back sides of the targets 21a and 21b, respectively. In this embodiment, the first and second magnet members 15a and 15b are positioned outside the vacuum chamber 11, but they may be positioned inside the vacuum chamber 11.

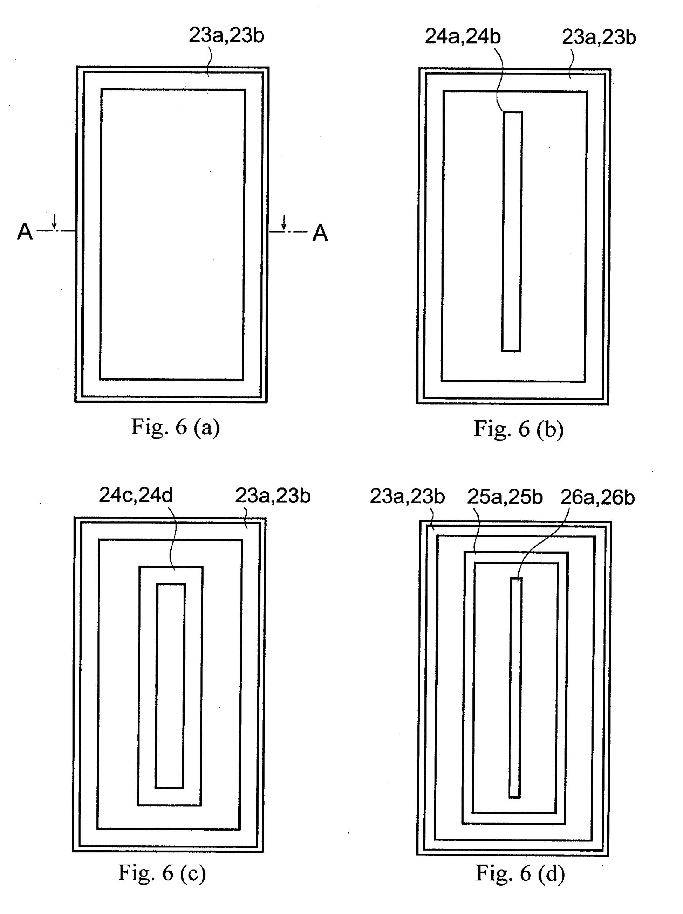

Fig. 6(a) shows a plan view of the first and second magnet members 15a and 15b. The first and second magnet members 15a and 15b shown in Fig. 1, and Figs. 2 and 3 mentioned later correspond to an A-A line cross sectional view of Fig. 6(a).

The first and second magnet members 15a and 15b include first and second yokes 29a and 29b, respectively, and first and second ring magnets 23a and 23b each having a ring-like shape are arranged on the surfaces of the first and second yokes 29a and 29b, respectively.

The first and second ring magnets 23a and 23b are located inside the region of outer peripheries of the first and second targets 21a and 21b, respectively, and are arranged along the outer peripheries of the first and second targets 21a and 21b, respectively. The first and second targets 21a and 21b are rectangular; and thus, the first and second ring magnets 23a and 23b are of a rectangular ring-like shape.

The different magnetic poles of the first and second magnets 23a and 23b are faced towards the side of the first and second target 21a and 21b, respectively.

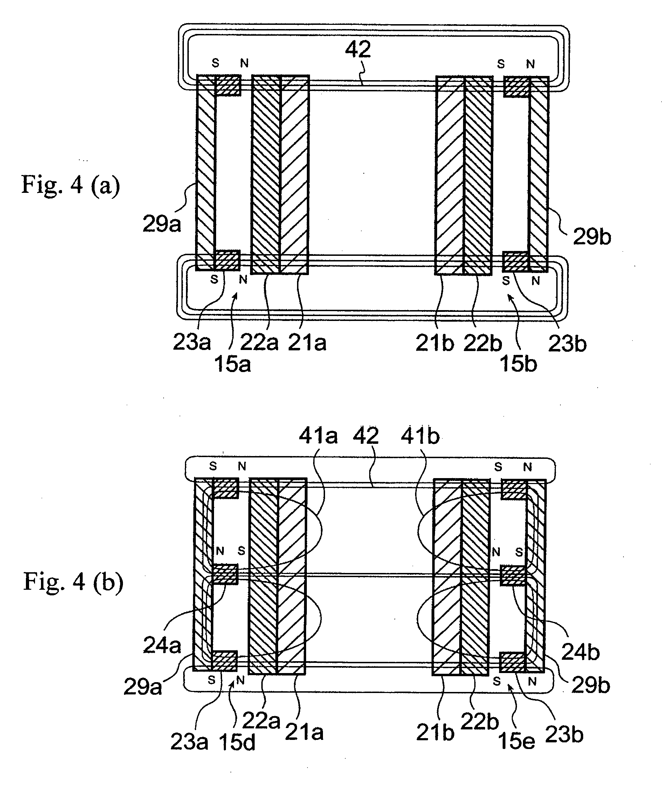

A reference number 42 of Fig. 4 (a) denotes lines of magnetic force formed by the first and second ring magnets 23a and 23b.

The lines 42 of magnetic force formed between the first and second ring magnets 23a and 23b surround the surfaces of the first and second targets 21a and 21b, respectively. Consequently, when the plasma is formed between the first and second targets 21a and 21b, the line 42 of magnetic force prevents the plasma from leaking out from the space between the first and second targets 21a and 22b to the outside.

The first and second targets 21a and 21b have the same shape (rectangle), and are arranged in parallel to each other such that their outlines are overlapped.

Long sides of the first and second targets 21a and 21b are faced to the transporting path 14 for the carrier 13.

The other long sides are faced to wall sides of the first sputtering chamber 16. To the wall sides, to which these long sides are faced, are connected, a reaction gas-introducing system 18 and a sputtering gas-introducing system (not shown) so that the reactive gas and the sputtering gas may be introduced into between the first and second targets 21a and 21b. Here, the reactive gas is oxygen gas, and the sputtering gas is argon gas. The reactive gas and the sputtering gas may be introduced from the same introducing system.

The surfaces of the first and second targets 21a and 21b are arranged vertically to the transporting path 14 for the carrier 13.

A shielding plate 31 is arranged between the first and second targets 21a and 21b and the transporting path 14. A release hole 32 which penetrates the shielding plate 31 in its thickness direction is formed at the shielding plate 31. Therefore, the release hole 32 is positioned between the transporting path 14 and the first and second targets 21a and 21b, as well.

Further, the shielding plate 31 is parallel to the transporting path 14; and thus, the release hole 32 is also parallel to the transporting path 14.

The edges of the release hole 32 comprise two straight sides 34a and 34b parallel to each other. These two sides 34a and 34b are located within planes vertical to the transporting path 14. One side, 34a, is located on an upstream side and the other side, 34b, is located on a downstream side in moving direction of the object 5 to be film-formed.

A reference sign W of Fig. 1 denotes a distance between the two sides 34a and 34b; that is, the width of the release hole 32.

A reference sign T of Fig. 1 denotes a distance of an area sandwiched between two planes at which each of the surfaces of the first and second targets 21a and 21b is located; that is, the distance T between the targets. A reference numeral 38 denotes a center line of the area sandwiched between the release hole 32 and the above two planes.

As later discussed, when the width W satisfies the following relationship W ≦ T × 1.6, desirably W ≦ T × 1.2, a transparent electroconductive film having a good film quality can be formed with sputtered particles having passed the release hole 32.

A space between the release hole 32 and the first and second targets 21a and 21b is covered with a tube 33. The shielding plate 31 and the tube 33 constitute a shielding body. The shielding body allows only the sputtered particles having passed the release hole 32 to reach the object 5 to be film-formed. The sputtered particles flying in a direction of oblique incidence onto the object 5 are shielded from reaching the object 5.

If any of the particles, other than the sputtered particles having passed the release hole 32, do not reach the object 5 to be film-formed, the same effect can be obtained even without the provision of the tube 33.

Next, the first and second magnet members 15a and 15b will be explained. A moving device (not shown) is connected to the first and second magnet members 15a and 15b so that the first and second magnet members may be moved relative to the first and second targets 21a and 21b, respectively.

As a result, the lines of magnetic force move along the surfaces of the first and second targets 21a and 21b so that erosion areas on the surfaces of the first and second targets 21a and 21b are enlarged.

The first and second magnet members 15a and 15b respectively move in directions vertical to the longitudinal directions of the first and second targets 21a and 21b (that is, in directions parallel to short-side directions) so that the erosion area may be made as wide as possible.

In addition, the first and second magnet members 15a and 15b are constructed to repeat reciprocal movements in a predetermined area at the same cycle; and, in addition, the movements of the first and second targets 21a and 21b are phase-shifted by a half cycle to each other.

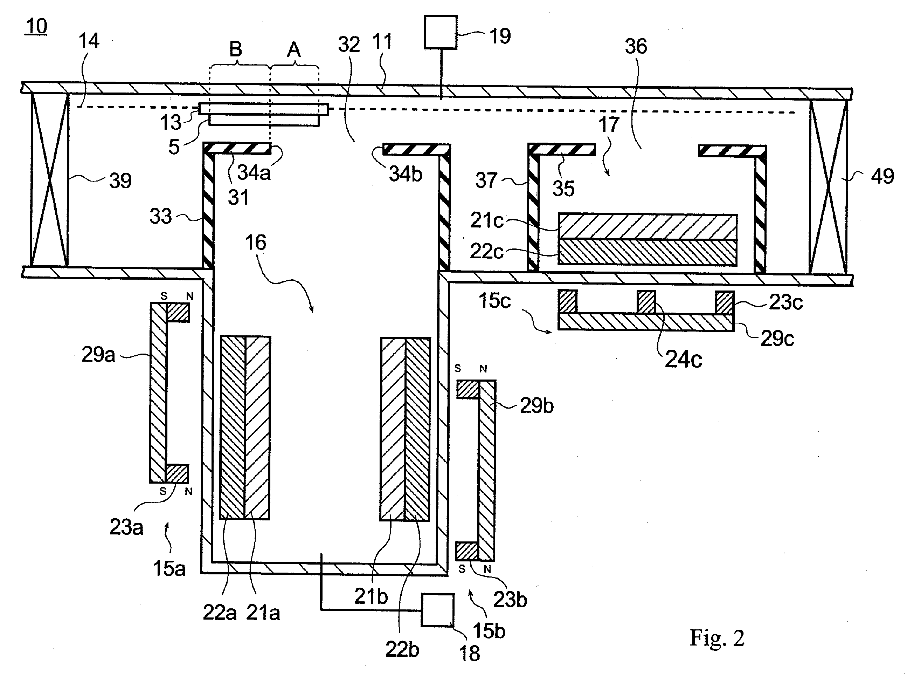

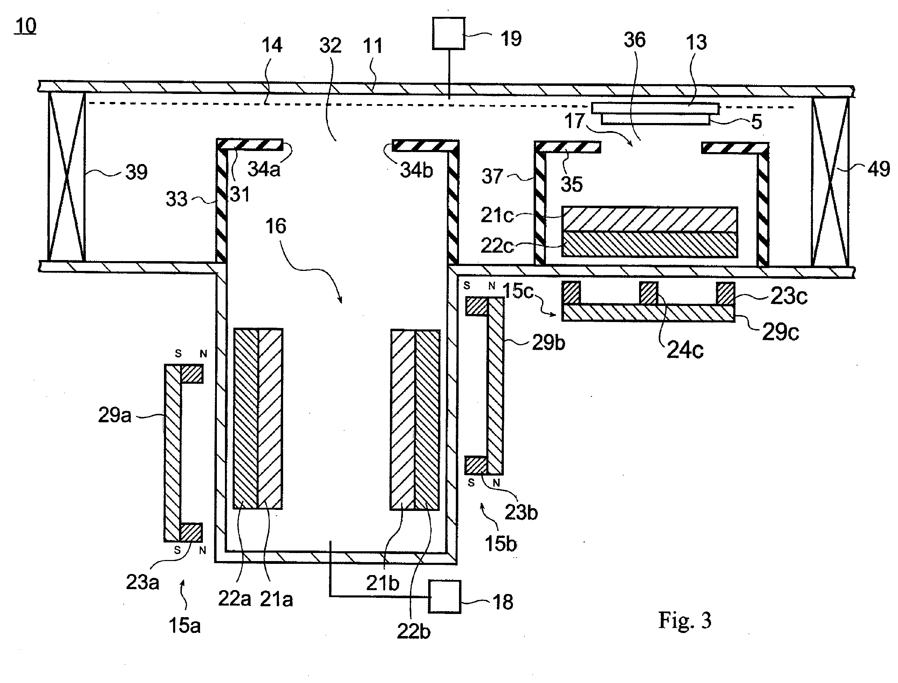

Therefore, when the first magnet member 15a moves nearest to the transporting path 14 for the carrier 13 as shown in Fig. 2, the second magnet member 15b moves farthest away from the transporting path 14 for the carrier 13. To the contrary, when the first magnet member 15a moves farthest away from the transporting path 14 for the carrier 13 as shown in Fig. 3, the second magnet member 15b moves nearest to the transporting path 14 for the carrier 13.

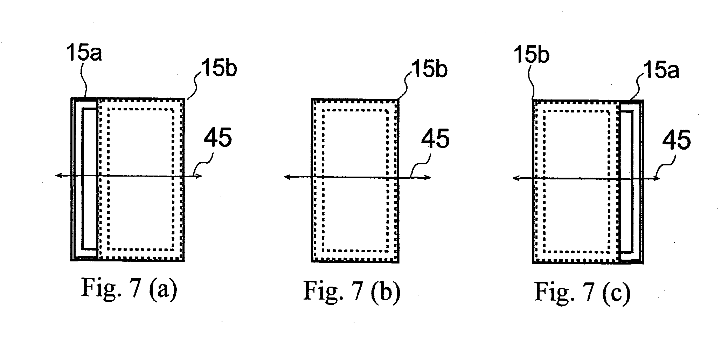

Figs. 7(a) to 7(c) show relative positional relationships between the first and second magnet members 15a and 15b phase-shifted by a half cycle. A reference number 45 denotes moving directions of the first and second magnet members 15a and 15b. The first and second magnet members 15a and 15b move straight periodically.

By the movements of the first and second magnet members 15a and 15b, the portions which have more largely sputtered amount on the surface of the first and second targets 21a and 21b approach the transporting path 14 alternately. With respect to the sputtered particles, which pop out from the first and second targets 21a and 21b and enter the release hole 32 onto the surface of the object 5 to be film-formed moving on the transporting path 14, when the amount of the particles irradiated from one of the targets is greater, the amount of the particles irradiated from the other target is smaller. As a result, the amount of the sputtered particles irradiated onto the object 5 is averaged.

The moving areas of the first and second magnet members 15a and 15b are ranges in which part of magnet members go outside the rear faces of the first and second targets 21a and 21b. The reciprocating distances of the first and second magnet members 15a and 15b are set equal.

Figs. 7 (a) to 7 (c) show the relative positional relationships between the first and second magnet members 15a and 15b phase-shifted by a half cycle. The reference number 45 denotes the moving directions of the first and second magnet members 15a and 15b. Figs. 7 (a) to 7 (c) show a case where the magnet members move straight periodically as one example of the movements.

The process of forming a thin film on the surface of the object 5 to be film-formed by using this sputtering apparatus 10 will be explained. As the first and second targets 21a and 21b and a third target 21c mentioned later, targets made of a transparent electroconductive material are used. Here, ITO was used as the transparent electroconductive material.

First, by operating the vacuum evacuating system 19 connected to the vacuum chamber 11, the interior of the vacuum chamber 11 is evacuated to a preset pressure. Then, a reactive gas (oxygen gas) and a sputtering gas (argon gas) are introduced into the vacuum chamber 11. After the interior of the first sputtering chamber 16 is stabilized at the preset pressure, plasma is formed in the space between the first and second targets 21a and 21b by applying AC voltage or DC voltage to the first and second targets 21a and 21b.

When the first and second magnet members 15a and 15b are moved as mentioned above and the surfaces of the first and second targets 21a and 21b are sputtered, a part of the sputtered particles reach the transporting path 14 for the object 5 to be film-formed through the release hole 32.

In this state, the carrier 13 is moved along the transporting path 14. In the state of Fig. 1, the object 5 to be film-formed is not faced towards the release hole 32 so that the sputtered particles having passed the release hole 32 cannot reach the object 5.

In Fig. 2, the object 5 to be film-formed moves toward the downstream direction from the state of Fig. 1, and a part of the downstream side of the object 5 is faced with the release hole 32, whereas the remaining upstream portion is faced not with the release hole 32 but with the shielding plate 31.

A reference sign A of Fig. 2 denotes a portion located on the downstream side and faced towards the release hole 32. A reference sign B denotes a portion located on the upstream side and not yet faced towards the release hole 32.

The distance between the surface of the shielding plate 31 and the surface of the object 5 to be film-formed is set as short as possible, and concretely set in a range of 0.5cm or more and 10cm or less.

Due to the above-described structural arrangement, the sputtered particles having passed the release hole 32 are irradiated onto the portion of the object 5 to be film-formed which is faced towards the release hole 32, but are not irradiated substantially onto the portion which is not faced towards the release hole.

The length of the two sides 34a and 34b of the release hole 32 vertical to the transporting path 14 is longer than the length of the film-forming area of the object 5 to be film-formed in a direction vertical to the transporting path 14. While the object 5 passes a position which is faced towards the release hole 32, the sputtered particles reach every part of the film-forming area.

Oxygen gas is fed according to need. In this embodiment, oxygen gas is provided from the reaction gas-introducing system 18. The transparent electroconductive film (ITO thin film, here) is formed on the surface of the object 5 to be film-formed with oxygen being supplied thereto.

The sputtered particles irradiated upon the surface of the object 5 to be film-formed are particles which pop out obliquely from the surfaces of the first and second targets 21a and 21b, and their energies are low. Consequently, the thin film is formed on the surface of the object 5 without damaging it.

While the object 5 to be film-formed does not face the release hole 32, the sputtered particles are not irradiated thereon. Therefore, there are many sputtered particles irradiated in a direction almost vertical to the object 5.

The plasma and electrons sputtering the first and second targets 21a and 21b are confined within the space between the first and second targets 21a and 21b. Thus, since the object 5 to be film-formed is not exposed to the plasma or the electrons, the surface of the object 5 is not damaged by the plasma or the electrons.

In the case where the film is formed on the object 5 to be film-formed with the object 5 being moved, it is ineffective that the overall thickness of the thin film to be formed is formed by the confronted targets 21a and 21b. In order to avoid damages upon the underlying film, it is effective that the film is formed only during an initial film-forming time period by the method for avoiding any damage and that the remaining thickness of the film is formed by the parallel flat plate type sputtering method having a large film-forming rate.

In this sputtering apparatus 10, a second sputtering chamber 17 is arranged on a downstream side of the position where the transporting path 14 for the object 5 to be film-formed faces the first sputtering chamber 16. After the object 5 passes the position where it faces the release hole 32 and a first transparent electroconductive film (ITO thin film, here) is formed, the object 5 moves toward the second sputtering chamber 17.

A third backing plate 22c is arranged inside the second sputtering chamber 17, and a third target 21c is provided on a surface of the third backing plate. A third magnet member 15c is arranged on a back side of the third target 21c.

In the third magnet member 15c, a third ring magnet 23c and a central magnet 24c are disposed on a yoke 29c. On a surface of the third target 21c are formed lines of magnetic force having a portion parallel to the surface of the third target 21c. The lines of magnetic force generate magnetron discharge. Consequently, the surface of the third target 21c is sputtered at a high efficiency.

The surface of the third target 21c is faced to the transporting path 14, and a surface of the object 5 to be film-formed passes in such a manner that a surface of the object 5 faces the surface of the third target 21c in parallel.

As in the case of the first and second targets 21a and 21b, a shielding plate 35 is disposed between the third target 21c and the transporting path 14. A release hole 36 is formed in such a manner that it penetrates the shielding plate 35 in its thickness direction.

This shielding plate 35 is parallel to the transporting path 14, as well, and the release hole 36 is also positioned between the transporting path 14 and the third target 21c, and parallel to the transporting path 14.

The release hole 36 is positioned just in front of the third target 21c. As shown in Fig. 3, while the object 5 to be film-formed passes the position facing the release hole 36, the sputtered particles which pop out vertically from the target 21c are irradiated vertically onto the object 5.

When the object 5 to be film-formed passes the release hole 36 above the third target 21c, the first transparent electroconductive film has been formed on the surface of the object 5 by means of the first and second targets 21a and 21b. The sputtered particles from the third target 21c are irradiated onto the surface of the first transparent electroconductive film so that a second transparent electroconductive film (ITO thin film, here) is formed without causing any damage upon other thin films (such as, the organic thin film located under the first transparent electroconductive film).

Oxygen is supplied to the structure of the second transparent electroconductive film with the oxygen gas introduced into the vacuum chamber 11.

A space between the third target 21c and the shielding plate 35 is surrounded by a tube 37, which also covers the periphery of the third target 21c.

The upper end of the tube 37 contacts the shielding plate 35. The particles flying in directions in which they enter, in an oblique manner, onto the surface of the object 5 to be film-formed are shielded by the shielding plate 35 and the tube 37 and are not irradiated onto the object 5. As a result, the transparent electroconductive film having a low resistivity and a high transmittance is formed.

The sputtered particles to form the second transparent electroconductive film are particles which pop out vertically from the surface of the third target 21c; and the amount of the particles is larger than that of the sputtered particles irradiated from the first and second target 21a and 21b, while the film-forming rate of the second transparent electroconductive film is higher than that in the case of the first transparent electroconductive film.

When the second transparent electroconductive film is to be formed by the third target 21c, the oxygen gas can be introduced into the second sputtering chamber 17.

### <Experimental Results>

The distances T between the first and second targets 21a and 21b are examined.

ITO targets are used as the first and second targets 21a and 21b. Magnets having the same structure as that of the third magnetic member 15c are used as the first and second magnet members 15a and 15b. An ITO thin film is formed on an object 5 to be film-formed made of a glass substrate in the state that the object 5 is in a stationary state. The ITO thin film is formed on the surface of the object 5 in a stationary state. Experimental results are shown in the following Table 1.

### Table 1

**Table 1 Distance between targets and attached amount of film**

| Distance between target and target (mm) | 20 | 40 | 60 | 100 | 150 | 200 |
|---|---|---|---|---|---|---|
| Attached amount of film | 5 | 11.6 | 19 | 29 | 36 | 45 |
| Intensity of magnetic field at the center position between target and target (gauss) | 850 | 700 | 520 | 300 | 150 | 50 |

"Film-attached amount" in the Table is taken as 100% in the case that the film is formed by the third target made of ITO for the same amount of time.

The above Table 1 shows that the distance T is set preferably at 40 mm or more and 150mm or less. As shown in Table 1, if the distance T between the confronted targets is narrow, the film-forming rate is slow, whereas if the distance between the targets is too large, the magnetic field generated in the space between the confronted targets cannot be effectively used.

Next, the dimension of the width W of the release hole 32 is determined based on the characteristics of the ITO thin film formed by using the above sputtering apparatus 10.

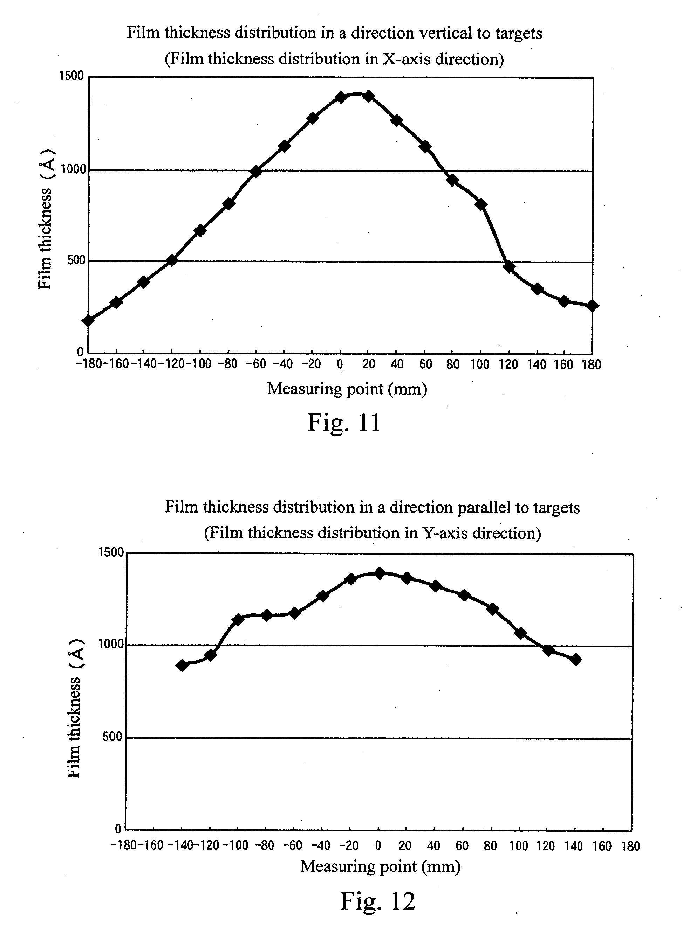

A substrate as an object to be film-formed is arranged at a front position of the space between the first and second targets 21a and 21b without the provision of the shielding plate 31 and the tube 33, and an ITO thin film is formed on a surface of the substrate. The distance T between the targets is 100mm. Regarding Figs. 11 to 15, ITO thin films are formed in such a state that objects to be film-formed are kept still.

First, Figs. 11 and 12 show film thickness distributions of the formed ITO thin films.

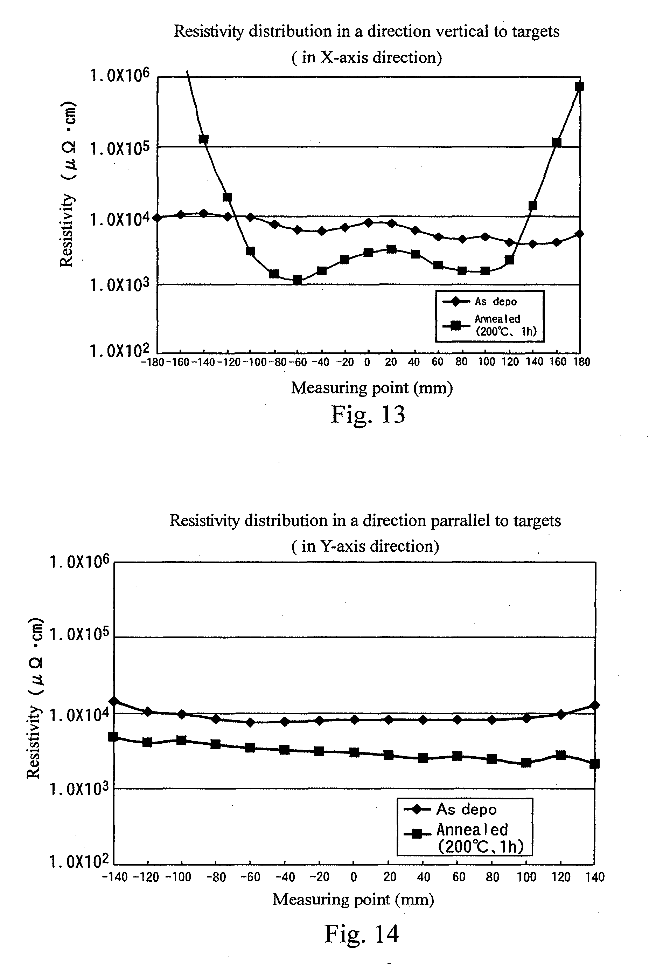

In Fig. 11 and Figs. 13 and 15, later discussed, the position on the substrate facing the center between and first and second targets 21a and 21b is set as zero; and the abscissa axis denotes the distance in a direction vertical to the first and second targets 21a and 21b from the zero point. In Fig. 12 and Fig. 14, later discussed, the center in the width direction of the first and second targets 21a and 21b is set as zero, and the abscissa axis denotes the distance in a direction parallel to the first and second targets 21a and 21b from the zero point.

Fig. 11 shows the film thickness distribution in the direction vertical to the first and second targets 21a and 21b. Fig. 12 shows the film thickness distribution in the direction parallel to the first and second targets 21a and 21b.

Numerical values of plots in Figs. 11 and 12 are shown in the following Tables 2a and 2b.

### Table 2

**Table 2a Direction vertical to targets (X-axis)**

| Measuring point | Film thickness ( Å ) |
|---|---|
| 180 | 265 |
| 160 | 290 |
| 140 | 355 |
| 120 | 478 |
| 100 | 813 |
| 80 | 946 |
| 60 | 1131 |
| 40 | 1265 |
| 20 | 1399 |
| 0 | 1396 |
| -20 | 1280 |
| -40 | 1130 |
| -60 | 993 |
| -80 | 813 |
| -100 | 672 |
| -120 | 508 |
| -140 | 389 |
| -160 | 277 |
| -180 | 178 |
| Film thickness distribution in X-axis direction | 66.95% |

| | |
|---|---|
| Film forming condition: AC power source Power 0.97kw (370V, 2.78A), Film forming in stationary state, Film-forming time period: 7min., O₂ : 3 × 10⁻⁵ Torr | |

**Table 2b Direction parallel to targets (Y-axis)**

| Measuring point | Film thickness ( Å ) |
|---|---|
| 140 | 927 |
| 120 | 975 |
| 100 | 1071 |
| 80 | 1200 |
| 60 | 1275 |
| 40 | 1327 |
| 20 | 1367 |
| 0 | 1396 |
| -20 | 1365 |
| -40 | 1268 |
| -60 | 1177 |
| -80 | 1165 |
| -100 | 1139 |
| -120 | 944 |
| -140 | 890 |
| Film thickness distribution in Y-axis direction | 22. 13% |

| | |
|---|---|
| Film forming condition: AC power source Power 0.97kw (370V, 2.78A), Film forming in stationary state, Film-forming time period: 7min., O₂ : 3 × 10⁻⁵ Torr | |

Figs. 11 and 12 and Fig. 13 to Fig. 15, later discussed, show results obtained when films are formed on the condition that the distance T between the targets is set at 100mm, the substrate is kept still, and the shielding plate 31 is not set.

Fig. 12 shows that the film thickness distribution in the direction parallel to the targets is relatively uniform. Although Fig. 11 shows that the film thickness distribution in the direction vertical to the targets is inferior to that in the direction parallel to the targets, there are no problems because the film is formed with the object to be film-formed being moved in the direction vertical to the targets.

Next, the resistivity distributions are shown in Figs. 13 and 14. Values of plots in Figs. 13 and 14 are shown in the following Tables 3 and 4.

### Table 3

**Table 3 Distributions in resistivity, etc. in a direction parallel to transporting path (X-axis direction)**

| | | As depo | | Annealed(200°C,1h) | |
|---|---|---|---|---|---|
| Measuring point | Film thickness ( Å ) | Sheet resistance ( Ω /square) | Resistivity (*µ* Ω ·cm) | Sheet resistance ( Ω /square) | Resistivity (*µ* Ω ·cm) |
| 180 | 265 | 2070 | 5485.5 | 273000 | 723450.0 |
| 160 | 290 | 1414 | 4100.6 | 38900 | 112810.0 |
| 140 | 355 | 1106 | 3926.3 | 3920 | 13916.0 |
| 120 | 478 | 862 | 4120.4 | 481 | 2299.2 |
| 100 | 813 | 617 | 5016.2 | 193.5 | 1573.2 |
| 80 | 946 | 483 | 4569.2 | 167.7 | 1586.4 |
| 60 | 1131 | 437 | 4942.5 | 167.7 | 1896.7 |
| 40 | 1265 | 481 | 6084.7 | 216 | 2732.4 |
| 20 | 1399 | 559 | 7820.4 | 230 | 3217.7 |
| 0 | 1396 | 570 | 7957.2 | 206 | 2875.8 |
| -20 | 1280 | 529 | 6771.2 | 176.7 | 2261.8 |
| -40 | 1130 | 531 | 6000.3 | 140.5 | 1587.7 |
| -60 | 993 | 636 | 6315.5 | 119.6 | 1187.6 |
| -80 | 813 | 943 | 7666.6 | 174.5 | 1418.7 |
| -100 | 672 | 1437 | 9656.6 | 451 | 3030.7 |
| -120 | 508 | 1953 | 9921.2 | 3630 | 18440.4 |
| -140 | 389 | 2840 | 11047.6 | 32200 | 125258.0 |
| -160 | 277 | 3740 | 10359.8 | 790000 | 2188300.0 |
| -180 | 178 | 5320 | 9469.6 | 2270000 | 4040600.0 |

### Table 4

**Table 4 Distributions in resistivity, etc. in a direction vertical to transporting path (Y-axis direction)**

| | | As depo | | Annealed(200°C, 1h) | |
|---|---|---|---|---|---|
| Measuring point | Film thickness ( Å ) | Sheet resistance ( Ω /square) | Resistivity (*µ* Ω ·cm) | Sheet resistance ( Ω /square) | Resistivity (*µ* Ω ·cm) |
| 140 | 927 | 1351 | 12523.8 | 231 | 2141.4 |
| 120 | 975 | 988 | 9633.0 | 279 | 2720.3 |
| 100 | 1071 | 808 | 8653.7 | 205 | 2195.6 |
| 80 | 1200 | 683 | 8196.0 | 204 | 2448.0 |
| 60 | 1275 | 627 | 7994.3 | 209 | 2664.8 |
| 40 | 1327 | 604 | 8015.1 | 189.4 | 2513.3 |
| 20 | 1367 | 591 | 8079.0 | 197.1 | 2694.4 |
| 0 | 1396 | 585 | 8166.6 | 212 | 2959.5 |
| -20 | 1365 | 581 | 7930.7 | 221 | 3016.7 |
| -40 | 1268 | 607 | 7696.8 | 251 | 3182.7 |
| -60 | 1177 | 641 | 7544.6 | 291 | 3425.1 |
| -80 | 1165 | 714 | 8318.1 | 324 | 3774.6 |
| -100 | 1139 | 846 | 9635.9 | 373 | 4248.5 |
| -120 | 944 | 1106 | 10440.6 | 428 | 4040.3 |
| -140 | 890 | 1591 | 14159.9 | 538 | 4788.2 |

Fig. 13 shows that the resistivity in the direction vertical to the targets rapidly increases as the position goes away from a range of -80mm or more and +80mm or less (1.6 times the distance T between the targets) around the zero point as the center.

More desirably, the resistivity is small in a range of -60mm or more and +60mm or less (1.2 times the distance T between the targets) around the zero point as the center.

In the case where the shielding plate 31 is not disposed, the sputtered particles reach even a region outside the range of 1.6 times the distance T between the targets when the object 5 to be film-formed comes close to the first and second targets 21a and 21b. Thus, an ITO thin film having a high resistivity is formed so that the resistivity in the film thickness direction increases.

Therefore, in order to decrease the resistivity of the transparent electroconductive film, it is only necessary to form an opening size of which is 1.6 times or less (more desirably 1.2 times or less) the distance T between the targets in the direction vertical to the targets around the zero point as the center and to make the sputtered particles reach the object 5 to be film-formed through the opening as the release hole 32.

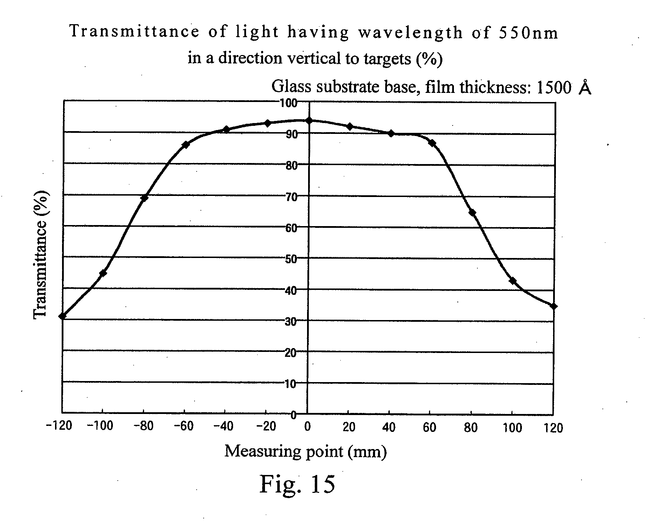

Next, Fig. 15 shows the transmittance of the ITO thin film (film thickness: 1500Å). Values of plots in Fig. 15 are shown in the following Table 5.

### Table 5

**Table 5 Transmittance distribution in a direction vertical to targets**

| Measuring point (distance from the center of the substrate) (mm) | Transmittance at 550nm (%) |
|---|---|
| -120 | 31 |
| -100 | 45 |
| -80 | 69 |
| -60 | 86 |
| -40 | 91 |
| -20 | 93 |
| 0 | 94 |
| 20 | 92 |
| 40 | 90 |
| 60 | 87 |
| 80 | 65 |
| 100 | 43 |
| 120 | 35 |

The transmittance is also high in the case where the width W of the opening is in a range of -80mm or more and +80mm or less (1.6 times the distance T between the targets) around the zero point as the center, i.e., more desirably, in the range of -60mm or more and +60mm or less (1.2 times the distance T between the targets) around the zero point as the center. Therefore, it shows that when only the sputtered particles in this range are allowed to reach the object 5 to be film-formed, the ITO thin film having a high transmittance can be formed.

Next, the following Table 6 shows the resistance value and the transmittance in the case that ITO thin films formed by the third target 21c made of ITO is formed on ITO thin films formed by the first and second targets 21a and 21b. The forming temperature is room temperature.

Magnets having the same structure as that of the third magnet member 15c are used as the first and second magnet members 15a and 15b.

### Table 6

**Table 6 Characteristics of ITO thin film formed**

| First and second targets => Third target | As depo Resistivity | As depo Transmittance Substrate base λ =550nm |
|---|---|---|
| 10nm ⇒ 90nm | 760 *µ* Ω cm | 84.5% |
| 20nm ⇒ 80nm | 830 *µ* Ω cm | 85% |
| 30nm ⇒ 70nm | 921 *µ* Ω cm | 84.4% |

The results are such that the thinner the film thickness of the first transparent electroconductive film, the lower the resistance value even when the total film thickness is the same. With respect to damages, an organic EL device is formed by forming films on an organic thin film with the first and second targets 21a and 21b and with the third target 21c in the mentioned order; and the brightness of the emitted light and the light emission-starting voltage are examined. When the first thin film adhering to the organic layer is formed by the first and second targets 21a and 21b, the brightness of the emitted light and the light emission-starting voltage are in the same levels as in the case of a vapor-deposited upper electrode film, even when the total film thickness increases by 100, 200 and 300 Å, respectively.

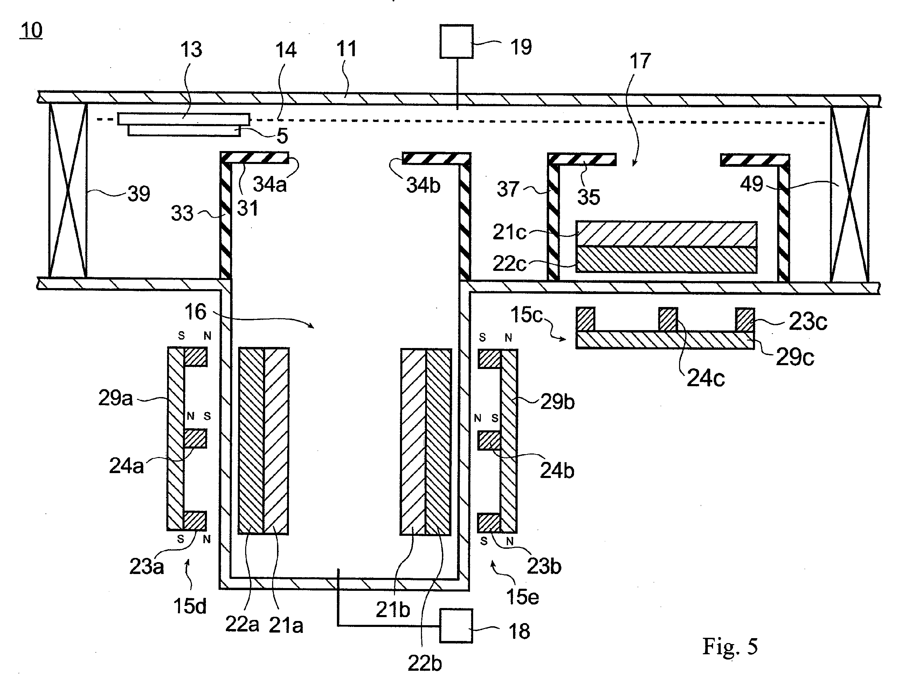

In the above embodiment, the different magnetic poles of the first and second magnet members 15a and 15b are faced to the individual rear faces of the targets, but the invention is not limited thereto. As shown in first and second magnet members 15d and 15e of Fig. 5, central magnets 24a and 24b may be arranged in the centers of the first and second ring magnets 23a and 23b, respectively, in such a manner that different poles of the central magnets are faced towards the rear faces of the targets.

Fig. 6(b) shows a plan view of the magnet members 15d and 15e. As shown in Fig. 4(b), in the magnet members 15d and 15e, magnetic fields 41a and 41b, which have components parallel to individual surfaces of the targets 21a and 21b, are formed above the surfaces of the targets 21a and 21b, respectively, in addition to the magnetic field 42 surrounding individual surfaces of the targets 21a and 22b. Thus, the targets 21a and 21b are magnetron sputtered.

Further, another magnet may be used in the present invention. For example, as shown in Fig. 6 (c), ring-shaped central magnets 24c and 24d may be arranged in such a manner that their magnetic poles opposite to the magnetic poles of the first and second ring magnets 23a and 23b respectively, are faced towards the rear faces of the first and second targets 21a and 21b, respectively.

In addition, as shown in Fig. 6(d), another ring-shaped central magnets 25a and 25b may be arranged in the first and second ring magnets 23a and 23b, respectively, and linear central magnets 26a and 26b may be further arranged inside the central magnets 25a and 25b, respectively.

In the above embodiment, the first and second magnet members 15a and 15b (and 15d and 15e) reciprocate at a constant frequency in the directions vertical to the long sides of the first and second targets 21a and 21b, respectively. However, the present invention is not limited thereto. In addition to the components in the directions vertical to the long sides, components in the directions along the long sides may be included. For example, the magnet members may perform a circular motion or an elliptical motion to the first and second targets 21a and 21b, respectively.

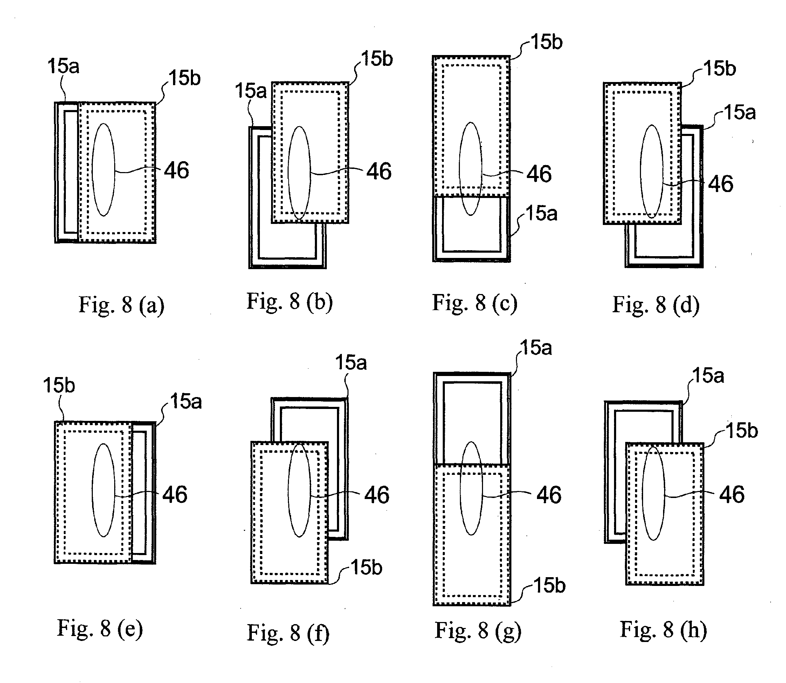

Figs. 8(a) to 8(h) are figures showing relative positional relationships in the case where the first and second magnet members 15a and 15b move along a moving direction 46 in an elliptical shape.

In this case, the first and second magnet members 15a and 15b are designed to move repeatedly within predetermined areas at the same cycle. When phase-shifted by a half cycle, the first and second magnet members 15a and 15b alternately come close to the object 5 to be film-formed. Accordingly, the amount of the sputtered particles irradiated on the object 5 is averaged so that the thickness distribution of the film on the surface of the object 5 is made uniform.

In the present invention, the moving speed of the object 5 to be film-formed is 10cm/min. to 100cm/min. Since the surfaces of the first and second targets 21a and 21b are arranged in parallel and spaced by about 100mm, the first and second magnet members 15a and 15b perform motions of two cycles or more, while the object 5 passes the space between the first and second targets 21a and 21b. Consequently, the motions of the first and second magnet members 15a and 15b are phase-shifted by a half cycle; and in addition, variations in the film-forming speed are averaged by moving of the first and second magnet members 15a and 15b.

Meanwhile, in the above embodiments, the first and second targets 21a and 21b are arranged in parallel. However, the targets may be arranged in angled positions, and then the object 5 to be film-formed may pass near a side where the distance between the targets is longer.

The above explanation is on a case where the transparent electroconductive film is formed. However, the targets in the apparatus according to the present invention are not limited to the transparent electroconductive material, but the apparatus according to the present invention can be used for forming a film of silicon oxide with the use of silicon targets and oxygen gas, an insulating film (such as, a silicon nitride film) with the use of silicon targets and nitrogen gas, and a metallic film with the use of metallic targets (such as aluminum).

## Claims

1. A sputtering apparatus (10), comprising:
a vacuum chamber (11);
a vacuum evacuating system for evacuating an interior of the vacuum chamber (11);
a sputtering gas-introducing system for introducing a sputtering gas inside the vacuum chamber (11);
first and second targets (21a; 21b) arranged in the vacuum chamber (11) with their surfaces spaced with a predetermined distance;
a transporting mechanism for transporting an object (5) to be film-formed along a transporting path (14) in the vacuum chamber (11) such that the object (5) to be film-formed passes a position on individual sides of the first and second targets (21a; 21b) in such a manner that a film-forming surface of the object (5) to be film-formed faces a space sandwiched between the first and second targets (21a; 21b); and
a shielding body (31, 33) arranged between the first and second targets (21a; 21b) and the transporting path (14), the shielding body (31, 33) having a release hole (32) through which sputtered particles released from the first and second targets (21a; 21b) and flying towards the transporting path (14) pass, wherein a third target (21c) is arranged in the vacuum chamber (11) a surface of the third target (21c) being faced towards the transporting path (14), and
wherein, after the object (5) to be film-formed passes through the position on individual sides of the first and second targets (21a; 21b), the object (5) to be film-formed passes through a front position of the third target (21c), facing the surface of the third target (21c).

2. The sputtering apparatus (10) according to claim 1, wherein the object (5) to be film-formed is transported in a direction where the object (5) to be film-formed passes perpendicular to the planes at which surfaces of the first and second targets (21a, 21b) are respectively positioned, and a width of the release hole (32) in a direction along the transporting path is 1.2 times or less than a distance between the surfaces of the first and second targets (21a, 21b).

3. The sputtering apparatus (10) according to claim 1, wherein the first and second targets (21a, 21b) are made of a transparent electroconductive material.

4. The sputtering apparatus (10) according to claim 3, wherein a reaction gas-introducing system for introducing oxygen gas is connected to the vacuum chamber (11).

5. The sputtering apparatus (10) according to claim 1, wherein the first, second and third targets (21a, 21b, 21c) are made of a transparent electroconductive material.

6. The sputtering apparatus according to claim 5, wherein a reaction gas-introducing system for introducing oxygen gas is connected to the vacuum chamber (11).

7. A method for producing a transparent electroconductive film for forming the transparent electroconductive film on a film-forming surface of an object (5) to be film-formed by sputtering first and second targets (21a, 21b) made of transparent electroconductive material which are arranged in a vacuum chamber (11) with their surfaces spaced with a predetermined distance, transporting the object (5) to be film-formed along a transporting path (14) in the vacuum chamber (11) in order to pass through the object (5) at a side position of the first and second targets (21a, 21b) in such a manner that the film-forming surface of the object (5) to be film-formed faces a space sandwiched between the first and second targets (21a, 21b), the method comprising the steps of:
arranging a shielding body (31, 33) between the first and second targets (21a, 21b) and the transporting path (14) in order to enter sputtering particles released from the first and second targets (21a, 21b) onto the object to pass through a release hole (32) formed in the shielding body (31,33); and
forming an upper transparent electroconductive film by sputtering a third target (21c) on a surface of a lower transparent electroconductive film formed by the first and second targets (21a, 21b) by making the object to be film-formed pass with its film-forming surface faced towards a surface of the third target (21c), while sputtering the third target (21c), which is made of a transparent electroconductive material and is arranged in the vacuum chamber (11) in such a manner that the surface of the third target faces (21c) the transporting path (14).

8. The transparent electroconductive film-producing method to transport the object (5) to be film-formed in a direction that the object (5) to be film-formed passes perpendicular to the planes at which surfaces of the first and second targets (21a, 21b) are respectively positioned according to claim 7,
wherein a width of the release hole (32) in a direction along the transporting path (14) is formed at 120% or less of a distance between the surfaces of the first and second targets (21a, 21b).

9. The transparent electroconductive film-producing method according to claim 7, further comprising the step of
sputtering the first and second targets (21a, 21b) while oxygen gas being introduced into the vacuum chamber (11).

## Patentansprüche

1. Sputter-Vorrichtung (10), welche umfasst:
eine Vakuumkammer (11);
ein Vakuum-Evakuierungssystem zum Evakuieren eines Innenraums der Vakuumkammer(11);
ein Sputter-Gaseinleitungssystem zum Einleiten eines Sputtergases in die Vakuumkammer (11);
einen ersten und einen zweiten Zielort (21a; 21b), die in der Vakuumkammer (11) angeordnet sind, wobei deren Flächen mit einem vorher bestimmten Anstand voneinander beabstandet sind;
einen Transportmechanismus zum Transportieren eines mit einem Film auszubildenden Objekts (5) längs eines Transportwegs (14) in der Vakuumkammer (11), so dass das mit einem Film auszubildende Objekt eine Position auf individuellen Seiten des ersten und zweiten Zielorts (21a; 21b) durchläuft, in einer Weise, dass eine mit einem Film auszubildende Fläche des mit einem Film auszubildenden Objekts (5) einem Raum zugewandt ist, der zwischen dem ersten und zweiten Zielort (21a; 21b) liegt; und
einen Abschirmkörper (31, 33), der zwischen dem ersten und zweiten Zielort (21a; 21b) und dem Transportweg (14) angeordnet ist, wobei der Abschirmkörper (31, 33) ein Freigabeloch (21) hat, durch welches gesputterte Partikel, welche vom ersten und zweiten Zielort (21a; 21b) freigegeben werden und in Richtung auf den Transportweg (14) fliegen, laufen, wobei ein dritter Zielort (21c) in der Vakuumkammer (11) angeordnet ist, wobei eine Fläche des dritten Zielorts (21c) dem Transportweg (14) zugewandt ist, und
wobei, nachdem das mit einem Film auszubildende Objekt (5) durch die Position auf individuellen Seiten des ersten und zweiten Zielorts (2 1 a; 21b) läuft, das mit einem Film auszubildende Objekt (5) durch eine Frontposition des dritten Zielorts (21c) läuft, wobei es der Fläche des dritten Zielorts (21c) zugewandt ist.

2. Sputter-Vorrichtung (10) nach Anspruch 1, wobei das mit einem Film auszubildende Objekt (5) in einer Richtung transportiert wird, wo das mit einem Film auszubildende Objekt (5) senkrecht zu den Ebenen läuft, bei denen Flächen des ersten und zweiten Zielorts (21a, 21b) entsprechend positioniert sind, und eine Breite des Freigabelochs (32) in einer Richtung längs des Transportwegs 1,2-mal oder weniger als eine Entfernung zwischen den Flächen des ersten und zweiten Zielorts (21 a, 21 b) beträgt.

3. Sputter-Vorrichtung (10) nach Anspruch 1, wobei der erste und zweite Zielort (21a, 21b) aus einem transparenten elektrisch leitfähigen Material hergestellt sind.

4. Sputter-Vorrichtung (10) nach Anspruch 3, wobei ein Reaktionsgas-Einleitungssystem zum Einleiten von Sauerstoffgas mit der Vakuumkammer (11) verbunden ist.

5. Sputter-Vorrichtung (10) nach Anspruch 1, wobei der erste, zweite und dritte Zielort (21a, 21b, 2 1 c) aus einem transparenten elektrisch leitfähigen Material hergestellt ist.

6. Sputter-Vorrichtung nach Anspruch 5, wobei ein Reaktionsgas-Einleitungssystem zum Einleiten von Sauerstoffgas mit der Vakuumkammer (11) verbunden ist.

7. Verfahren zum Herstellen eines transparenten elektrisch leitfähigen Films zum Bilden des transparenten elektroleitenden Films auf einer Filmbildungsfläche eines mit einem Film auszubildenden Objekts (5) durch Sputtern eines ersten und eines zweiten Zielorts (21a, 21b), die aus einem transparenten elektrisch leitfähigen Material bestehen, welche in einer Vakuumkammer (11) angeordnet sind, wobei ihre Flächen mit einem vorher bestimmten Abstand voneinander beabstandet sind, Transportieren des mit einem Film auszubildenden Objekts (5) längs eines Transportwegs (14) in der Vakuumkammer, um das Objekt (5) an einer Seitenposition des ersten und des zweiten Zielorts (21a, 21b) zu durchlaufen, in einer Weise, das die Filmbildungsfläche des mit einem Film auszubildenden Objekts (5) einem Raum zugewandt ist, der zwischen dem ersten und dem zweiten Zielort (21a, 21b) angeordnet ist, wobei das Verfahren folgende Schritte umfasst:
Anordnen eines Abschirmkörpers (31, 33) zwischen dem ersten und dem zweiten Zielort (21 a, 21 b) und dem Transportweg (14), um Sputterpartikel, die vom ersten und dem zweiten Zielort (21a, 21b) freigegeben werden, dem Objekt zuzuführen, damit sie durch ein Freigabeloch (21), welches im Abschirmkörper (31, 33) gebildet ist, laufen; und
Bilden eines oberen transparenten elektrisch leitfähigen Films durch Besputtem eines dritten Zielorts (21 c) auf einer Fläche eines unteren transparenten elektrisch leitfähigen Films, der durch den ersten und zweiten Zielort (21a, 21b) gebildet ist, wobei man das mit einem Film auszubildende Objekt mit seiner Filmbildungsfläche, die in Richtung des dritten Zielorts (21 c) zugewandt ist, laufen lässt, während der dritte Zielort (21c) besputtert wird, der aus einem transparenten elektrisch leitfähigen Material hergestellt ist und in der Vakuumkammer (11) angeordnet ist, in einer Weise, dass die Fläche des dritten Zielorts (21c) dem Transportweg (14) zugewandt ist.

8. Verfahren für transparentes elektrisch leitfähiges Filmbilden, um das mit einem Film auszubildende Objekt (5) in einer Richtung zu transportieren, dass das mit dem Film auszubildende Objekt (5) senkrecht zu den Ebenen läuft, bei denen Flächen des ersten und des zweiten Zielorts (21 a, 21 b) entsprechend positioniert sind, nach Anspruch 7,
wobei eine Breite des Freigabelochs (32) in einer Richtung längs des Transportwegs (14) bei 120% oder weniger eines Abstandes zwischen den Flächen des ersten und des zweiten Zielorts (21a, 21b) ist.

9. Verfahren für transparentes elektrisch leitfähiges Filmbilden nach Anspruch7, welches außerdem folgenden Schritt umfasst:
Besputtern des ersten und des zweiten Zielorts (21 a, 21 b) mit Sauerstoffgas, das in die Vakuumkammer (11) eingeführt wird.

## Revendications

1. Appareil de pulvérisation (10) comprenant:
une chambre de vide (11);
un système de mise sous vide pour mettre sous vide un intérieur de la chambre de vide (11);
un système d'introduction de gaz de pulvérisation pour introduire un gaz de pulvérisation à l'intérieur de la chambre de vide (11);
des première et deuxième cibles (21a; 21b) agencées dans la chambre de vide (11) avec leurs surfaces espacées avec une distance prédéterminée;
un mécanisme de transport pour transporter un objet (5) à former en film le long d'une trajectoire de transport (14) dans la chambre de vide (11) de sorte que l'objet (5) à former en film passe par une position sur les côtés individuels des première et deuxième cibles (21a; 21b) de sorte qu'une surface de formation de film de l'objet (5) à former en film fait face à un espace pris en sandwich entre les première et deuxième cibles (21a; 21b); et
un corps de protection (31, 33) agencé entre les première et deuxième cibles (21a; 21b) et la trajectoire de transport (14), le corps de protection (31, 33) ayant un trou de libération (32) à travers lequel passent des particules pulvérisées libérées des première et deuxième cibles (21a; 21b) et volant vers la trajectoire de transport (14), dans lequel une troisième cible (21c) est agencée dans la chambre de vide (11), une surface de la troisième cible (21c) étant orientée vers la trajectoire de transport (14), et
dans lequel, après que l'objet (5) à former en film est passé par la position sur les côtés individuels des première et deuxième cibles (21a; 21b), l'objet (5) à former en film passe par une position avant de la troisième cible (21c), faisant face à la surface de la troisième cible (21c).

2. Appareil de pulvérisation (10) selon la revendication 1, dans lequel l'objet (5) à former en film est transporté dans une direction dans laquelle l'objet (5) à former en film passe perpendiculairement aux plans au niveau desquels les surfaces des première et deuxième cibles (21a, 21b) sont respectivement positionnées, et une largeur du trou de libération (32) dans une direction le long de la trajectoire de transport représente 1,2 fois ou moins d'une distance entre les surfaces des première et deuxième cibles (21a, 21b).

3. Appareil de pulvérisation (10) selon la revendication 1, dans lequel les première et deuxième cibles (21a, 21b) sont réalisées avec un matériau transparent électro-conducteur.

4. Appareil de pulvérisation (10) selon la revendication 3, dans lequel un système d'introduction de gaz de réaction pour introduire du gaz oxygène est raccordé à la chambre de vide (11).

5. Appareil de pulvérisation (10) selon la revendication 1, dans lequel les première, deuxième et troisième cibles (21a, 21b, 21c) sont réalisées avec un matériau transparent électro-conducteur.

6. Appareil de pulvérisation selon la revendication 5, dans lequel un système d'introduction de gaz de réaction pour introduire du gaz oxygène est raccordé à la chambre de vide (11).

7. Procédé pour produire un film transparent électro-conducteur pour former le film transparent électro-conducteur sur une surface de formation de film d'un objet (5) à former en film en pulvérisant des première et deuxième cibles (21a, 21b) réalisées avec un matériau transparent électro-conducteur qui sont agencées dans une chambre de vide (11) avec leurs surfaces espacées avec une distance prédéterminée, transportant l'objet (5) à former en film le long d'une trajectoire de transport (14) dans la chambre de vide (11) afin de passer à travers l'objet (5) au niveau d'une position latérale des première et deuxième cibles (21a, 21b) de sorte que la surface de formation de film de l'objet (5) à former en film fait face à un espace pris en sandwich entre les première et deuxième cibles (21a, 21b), le procédé comprenant les étapes consistant à:
agencer un corps de protection (31, 33) entre les première et deuxième cibles (21a, 21b) et la trajectoire de transport (14) afin de faire entrer des particules de pulvérisation libérées des première et deuxième cibles (21a, 21b) sur l'objet pour passer à travers un trou de libération (32) formé dans le corps de protection (31, 33); et
former un film transparent électro-conducteur supérieur en pulvérisant une troisième cible (21c) sur une surface d'un film transparent électro-conducteur inférieur formé par les première et deuxième cibles (21a, 21b) en faisant passer l'objet à former en film avec sa surface de formation de film orientée vers une surface de la troisième cible (21c), tout en pulvérisant la troisième cible (21c), qui est réalisée avec un matériau transparent électro-conducteur et est agencée dans la chambre de vide (11) de sorte que la surface de la troisième cible (21c) fait face à la trajectoire de transport (14).

8. Procédé pour produire un film transparent électro-conducteur afin de transporter l'objet (5) à former en film dans une direction dans laquelle l'objet (5) à former en film passe perpendiculairement par rapport aux plans au niveau desquels des surfaces des première et deuxième cibles (21a, 21b) sont respectivement positionnées selon la revendication 7,
dans lequel une largeur du trou de libération (32) dans une direction le long de la trajectoire de transport (14) est formée à 120% ou moins d'une distance entre les surfaces des première et deuxième cibles (21a, 21b).

9. Procédé pour produire un film transparent électro-conducteur selon la revendication 7, comprenant en outre l'étape consistant à :
pulvériser les première et deuxième cibles (21a, 21b) tout en introduisant du gaz oxygène dans la chambre de vide (11).
